# EUROPÄISCHE PATENTSCHRIFT

(11) **EP 1 708 555 B1**
(45) Veröffentlichungstag und Bekanntmachung des Hinweises auf die Patenterteilung: **18.07.2007**
(21) Anmeldenummer: 05007167.9
(22) Anmeldetag: 01.04.2005
(51) Int. Cl.: H05K 5/00

(54) **Lagerungs-Anordnung**
Suspension device
Dispositif de suspension

(43) Veröffentlichungstag der Anmeldung: 04.10.2006
(73) Patentinhaber: Knürr AG, 8117 Fällanden (CH)
(72) Erfinder: Wiedemeier, Armin, 8600 Dübendorf (CH); Weber, Markus, 8105 Watt-Regensdorf (CH); Zbinden, Markus, 9032 Engelburg (CH); Tschopp, Walter, 9606 Bütschwil (CH); Amacker, Andreas, 8400 Winterthur (CH)
(74) Vertreter: Heim, Hans-Karl

(56) Entgegenhaltungen:
- EP-A- 0 327 809
- FR-A- 2 411 141
- US-A- 3 507 974
- US-A- 3 997 819
- US-A- 4 483 444
- US-A- 5 160 357

## Beschreibung

Die Erfindung betrifft eine Lagerungs-Anordnung gemäß dem Oberbegriff des Anspruchs 1 und einen Gerätekoffer mit der erfindungsgemäßen Lagerungs-Anordnung.

Gattungsgemäße Lagerungs-Anordnungen werden verwendet, um stoßempfindliche Baugruppen vor Vibrationen und Schwingungen in Gehäusen zu schützen. Solche Gehäuse weisen beispielsweise einen Außenrahmen und einen Innenrahmen auf. Im Innenrahmen sind elektrische und elektronische Baugruppen auf herkömmliche Weise befestigt. Beispiele für diese Baugruppen sind Messgeräte für einen Feldversuch oder Kommunikationseinrichtungen. Der Innenrahmen selbst steht mit dem Außenrahmen nur durch sogenannte Dämpfungselemente in Kontakt. Durch diese Dämpfungselemente ist es möglich, Schwingungen und Krafteinwirkung auf den äußeren Rahmen nicht auf den inneren Rahmen zu übertragen, da die Kräfte, zumindestens größtenteils von den Dämpfungselementen absorbiert werden. Die herkömmlich genutzten Dämpfungselemente weisen oft als zentrales Element eine Feder, meist eine Spiralfeder, auf, um die notwendige Dämpfungswirkung zu erzielen und sind in der Art von Stoßdämpfern in Automobilen ausgelegt.

Im Allgemeinen ist der Außenrahmen als ein Gehäuse ausgebildet. Um den Transport einer solchen Vorrichtung leichter bewerkstelligen zu können, besitzt der Außenrahmen einen verschließbaren Deckel. Ziel hierbei ist es, die in den Innenrahmen eingebauten Baugruppen vor äußeren Witterungseinflüssen wie Feuchtigkeit oder Schmutz möglichst gut zu schützen. Zu diesem Zweck weist ein Gehäuse im Stand der Technik eine Dichtungskante im Bereich des Deckels auf, um so einen dichten Verschluss des Gehäuses zu gewährleisten. Der Deckel wird meist mit Drehverschlüssen an dem Gehäuse befestigt.

Zum Bedienen der in dem Innengehäuse eingebrachten Baugruppen ist es notwendig, den Deckel zu entfernen. Die Baugruppen bilden meist an der, der Öffnung des Deckels zugewandten Seite mittels Ihrer Frontplatten eine ebene Front. Dadurch, dass die Baugruppen in dem Schwingrahmen angebracht sind, welcher sich durch die Dämpfungselemente in einem gewissen Abstand zu dem äußeren Rahmen, in diesem Fall dem Gehäuse, befindet, können durch diesen Spalt Feuchtigkeit und Schmutz auf die Rückseiten der Baugruppen gelangen. Zu diesem Zweck ist bei herkömmlichen Gehäusen ein Gummibalg vorgesehen, der zwischen dem Schwingrahmen und dem äußeren Gehäuse angebracht wird. Zur Befestigung werden Teile dieses Gummibalgs unter die Frontplatten der Bauelemente eingeklemmt.

Die Anbringung eines solchen Gummibalgs ist zum einen äußerst aufwändig, da nicht viel Platz zur Montage in dem Zwischenraum vorhanden ist. Zum anderen werden die Schwingungseigenschaften des Innenrahmens durch diesen Gummiblag negativ beeinflusst, da er eine zusätzliche Verbindung zwischen Innengehäuse und Außengehäuse darstellt. Da der Gummibalg als Abdichtung dienen soll, muss er sowohl am Innen- wie auch am Außengehäuse anliegen. Hierdurch entsteht eine weitere Verbindung zwischen den beiden Gehäusen, neben den bestehenden Verbindungen durch die Dämpfungselemente.

Ein gattungsgemäßes, tragbares Schutzgehäuse mit Schwingungsdämpfern ist aus der EP 0 327 809 A1 bekannt. Hierbei wird versucht, den inneren Bereich des Innenrahmens unter anderem durch ein Metallnetz, ein Gewebe oder eine Folie von der Umgebung abzuschirmen. Dies wird vor allem in Bezug auf eine EMV-Abdichtung ausgeführt. Eine solche Einrichtung dichtet auch vor Schmutz und dergleichen ab. Bei dieser Ausführung besteht aber auch das Problem, dass die zusätzlichen Abdichtungen die Schwingungseigenschaften des Innenrahmens ungünstig beeinflussen.

Zur Abdichtung und Dämpfung einwirkender Kräfte werden bei diesem Schutzgehäuse zwei aufwändige separate Systeme mit Dämpfungselementen und Gummibalg-Einrichtungen eingesetzt.

Ein anderes Gehäuse für schwingungs- und stoßempfindliche Geräte ist aus DE-A-3323624 bekannt. Hierin wird versucht, durch ein speziell ausgebildetes und geformtes Dichtungs- und Schwingelement, welches zwischen dem Außen- und dem Innengehäuse angeordnet ist, eine Dichtfunktion und eine Schwingungsminderung zu erreichen. Um dieses Dichtelement ohne weitere Hilfsmittel zwischen den beiden Gehäusen zu befestigen, weist dieses eine komplexe Form auf, die in der Herstellung teuer ist. Ebenfalls ist es kompliziert, das Dichtelement zwischen die beiden Gehäuse einzusetzen.

Der Erfindung liegt die **Aufgabe** zugrunde, ein vereinfachtes Konstruktionsprinzip für eine Lagerungs-Anordnung und einen Gerätekoffer zu schaffen, welches geeignet ist, beide Funktionen, Dämpfung und Dichtung zu realisieren und für diesen Anwendungsbereich flexibel und anpassbar zu sein.

Die Aufgabe wird erfindungsgemäß durch eine Lagerungs-Anordnung mit den Merkmalen des Anspruchs 1 gelöst. Demnach ist vorgesehen, dass die Dämpfungsvorrichtung im Wesentlichen als mindestens ein zwischen Innen- und Außenbaugruppe umlaufendes elastisches Polymerprofil mit Dichtwirkung zwischen Innen- und Außenbaugruppe, insbesondere mit zwei Polymerprofilen, ausgebildet ist und dass weiterhin die Innen- und Außenbaugruppe mit einer Anlageeinrichtung für das bzw. die elastische(n) Polymerprofile ausgebildet ist bzw. sind.

Ferner wird die Erfindung in einem Gerätekoffer gemäß Anspruch 18 mit einem Außengehäuse und einem darin angebrachten Innenschwingrahmen realisiert.

Weitere vorteilhafte Ausführungsformen sind in den abhängigen Ansprüchen angegeben.

Ein Grundgedanke der Erfindung ist es, die Dämpfungsfunktion und die Dichtungsfunktion in einem System bzw. einer Anordnung zu kombinieren. Dies wird dadurch erreicht, dass die Dämpfungsvorrichtung aus einem elastischen Polymerprofil gebildet ist. Des Weiteren weisen die Innen- und Außenbaugruppe mindestens eine Anlageeinrichtung für das elastische Polymerprofil auf. Durch diese Anlageeinrichtung ist es möglich, das Polymerprofil in geeigneter Weise zwischen dem Außenrahmen und dem Innenrahmen zu fixieren, um somit eine besonders gute Dämpfung zu realisieren. Weiterhin wird mit dieser Dämpfungsanordnung erreicht, dass die herkömmlichen, meist aus Federn bestehenden Dämpfungselemente überflüssig werden.

Durch das Verwenden eines Polymerprofils zwischen der Außenbaugruppe und der Innenbaugruppe wird der Spalt zwischen diesen beiden Baugruppen geschlossen. Folglich wird die Abdichtung der in die Innenbaugruppe eingebrachten elektrischen und elektronischen Baugruppen verbessert und sichergestellt.

Prinzipiell kann die Anlageeinrichtung jede Form aufweisen, die geeignet ist, das elastische Polymerprofil in einer Lage zwischen der Innen- und der Außenbaugruppe zu fixieren oder einzuspannen, ohne die Dämpfungseigenschaften des Polymerprofils negativ zu beeinflussen. Es ist erfindungsgemäß, wenn die Anlageeinrichtung zwei gegeneinander weisende, insbesondere parallele Schrägflächen aufweist, zwischen denen das Polymerprofil vorgesehen ist. Durch das Ausbilden der Anlageeinrichtung mit zwei Schrägflächen kann eine besonders gute Dämpfung durch das Polymerprofil erreicht werden. Auch wird das Polymerprofil durch diese schrägen Flächen ausreichend in seiner Position und Lage fixiert, so dass es als Dämpfungselement nicht verrutschen kann.

Für eine Optimierung der Dämpfung der Innenbaugruppe ist vorgesehen, jeweils mindestens eine Anlageeinrichtung an beiden Endbereichen der Innenbaugruppe für das Polymerprofil vorzusehen und die beiden Anlageeinrichtungen im Wesentlichen spiegelsymmetrisch zur Mittelachse der Innenbaugruppe auszulegen. Durch ein solches Auslegen der Anlageeinrichtungen an beiden Endbereichen der Innenbaugruppe können Schwingungen besonders gut aufgenommen und gedämpft werden. Durch das achssymmetrische Auslegen der Anlageeinrichtung können Stöße von vorne bzw. von hinten durch das jeweils näheste Polymerprofil gut gedämpft werden, ohne dass große Schwingungsamplituden entstehen. Außerdem wird durch die Spiegelsymmetrie der Anlageeinrichtung eine gute Zentrierung der inneren Baugruppe in der äußeren Baugruppe in Bezug auf die Mittelachse erreicht.

Besonders vorteilhaft ist es, wenn die Anlageeinrichtung als Führungs- oder Einspanneinrichtung ausgebildet ist. Hierdurch wird erreicht, dass das eingespannte Polymerprofil ohne zusätzliche Fixierungsmittel an der gewünschten Position gehalten wird. Auch kann durch die Spanneinrichtung eine gewünschte Vorspannung auf das Polymerprofil ausgeübt werden, womit die Dämpfungscharakteristik des Polymerprofils entsprechend der Eigenschaften der Innenbaugruppe, abhängig vom Gewicht, eingestellt werden kann. Diese Führungseinrichtung sorgt dafür, dass selbst bei großen Schwingungsauslenkungen das Polymerprofil wieder zurück in die gewünschte Ausgangsposition geführt wird. Die Führungseinrichtung kann vorzugsweise käfigartig ausgebildet sein, wobei ein Ausweichen des Profils bei Schwingungen verhindert werden kann. Auch können Fortsätze an den Rändern der Anlageeinrichtung vorgesehen sein. Es wird folglich erreicht, dass das Polymerprofil gut fixiert ist und trotzdem sehr flexibel auf äußere Schwingungsanregung reagieren kann, also seine volle Dämpfungswirkung entwickeln kann.

Um die Dämpfungseigenschaften des Polymerprofils geeigneter anzupassen, kann es als Voll- oder als Hohlprofil ausgebildet sein. Ein Vollprofil hat gegenüber einem Hohlprofil den Vorteil, dass größere Gewichte, und Kräfte die beispielsweise ein Hohlprofil sehr komprimieren können, besser aufgenommen bzw. abgefangen werden können. Ein Hohlprofil bietet den Vorteil, dass es sich flexibler verformen kann und damit eine größere Dämpfungswirkung erreicht werden kann, wenn kleinere Kräfte einwirken.

Um eine gute Dämpfungswirkung zwischen der Außenbaugruppe und der Innenbaugruppe durch das Polymerprofil realisieren zu können, steht dieses großflächig mit der Anlageeinrichtung in Wirkverbindung. Durch eine großflächige Wirkverbindung werden die Kräfte, die von der Außenbaugruppe auf das Polymerprofil einwirken von dem gesamten Profil aufgenommen. So kommt es zu keiner punktuellen Belastung des Profils, wodurch die Lebensdauer der Polymere verringert werden würde. Des Weiteren hat eine großflächige Wirkverbindung den Vorteil, dass die auf das Polymerprofil einwirkenden Kräfte vom gesamten Profil aufgenommen werden und somit das Profil punktuell gesehen keinen so großen Dämpfungsgrad aufweisen muss.

Grundsätzlich kann das Polymerprofil in beliebiger Form ausgeführt sein. Besonders zweckmäßig kann es als ring-, oval- oder kreisförmiges Hohlprofil ausgebildet sein. Ein Vorteil einer ring-, oval- oder kreisförmigen Form des Polymerprofils ist, dass beim Einsetzen des Profils zwischen die beiden Baugruppen, nicht darauf geachtet werden muss, dass eine bestimmte Position in Bezug auf die beiden anliegenden Baugruppen eingenommen werden muss. Es gibt also keinen Bereich des Profils, der zum Außenrahmen zeigen muss und keinen, der zum Innenrahmen zeigen sollte. Des Weiteren kann durch die ringförmige Form eine besonders gute und problemlose Kraftübertragung der Außenbaugruppe auf das Polymerprofil erreicht werden und durch den vorhandenen Hohlraum eine besonders gute Dämpfungswirkung erzielt werden. Durch das Zusammenfließen dieser beiden Eigenschaften von ringförmig und Hohlprofil, wird folglich ein einfach zu handhabendes und trotzdem gut dämpfendes Polymerprofil ausgebildet.

In einer vorteilhaften Ausführungsform ist das Polymerprofil einstückig umlaufend oder segmentiert ausgebildet. Eine einstückige Ausführungsform des Polymerprofils ist besonders kosteneffizient und einfach zu produzieren. Auf der anderen Seite kann durch eine Segmentierung des Polymerprofils erreicht werden, dass das Polymerprofil in Teilbereichen mit unterschiedlicher Härte und/oder Dämpfungscharakteristik ausgebildet ist. Dieses Vorgehen bietet die Möglichkeit, das Polymerprofil speziell auf bestimmte eintretende Schwingungsverhalten abzustimmen. So treten beispielsweise bei einem Transport mit einem LKW rüttelnde Bewegungen auf, die anders abgefedert werdenkönnen als Stöße, die beispielsweise durch das auf den Boden Fallen ausgelöst werden. Auch kann ein geeignetes Zusammenspiel unterschiedlicher Härte und Dämpfungscharakteristika bei einer Segmentierung vorteilhaft dazu genutzt werden, verschiedene Schwingungstypen möglichst gut zu dämpfen, dadurch dass einzelne Segmente jeweils auf speziell einen Schwingungstyp abgestimmt sind. Eine solche Abstimmung kann durch Verwenden unterschiedlicher Polymere erreicht werden.

Eine weitere Möglichkeit, die Härte und Dämpfungseigenschaften zu variieren, besteht darin, die unterschiedlichen Polymere nicht in einzelnen Segmenten getrennt anzuordnen, sondern einen integrierten Übergang zwischen den einzelnen Polymeren zu verwenden. Hierdurch ist es möglich, die Eigenschaften des Profils kontinuierlich oder auch abrupt für bestimmte Bereiche zu verändern.

Es besteht weiterhin die Möglichkeit, die Dämpfungs- und/oder Härtecharakteristik des Polymerprofils mittels eines in das Hohlprofil oder in einzelne Segmente des Hohlprofils eingebrachten Mediums zu verändern und einzustellen. Auch kann die Einspannung des Polymerprofils in der Anlageeinrichtung hiermit beeinflusst werden. Das Hohlprofil kann beispielsweise mit geeigneten Fluiden gefüllt sein. Eine andere Möglichkeit ist, das Hohlprofil mit Luft höheren Drucks zu füllen. Auch ist denkbar, den Hohlraum mit einem geeigneten Schaum auszuschäumen. Ist das Hohlprofil segmentiert, so ist es möglich, in die einzelnen Segmente dieses Profils unterschiedliche Medien zu füllen, um unterschiedliche Dämpfungs- und Härtecharakteristika zu erreichen. Dies kann genützt werden, um den Dämpfungsgrad des Polymerprofils auf die Rahmenbedingungen, wie das Gewicht der Innenbaugruppe oder die auf die Außenbaugruppe einwirkenden Stöße, abzustimmen.

Um die Dämpfungs- und Härtecharakteristika des Polymerprofils flexibel an die Rahmenbedingungen anpassen zu können, hat es sich als vorteilhaft herausgestellt, eine Einrichtung zum Variieren der Menge und/oder des Druckes des in das Hohlprofil eingebrachten Mediums vorzusehen. Durch diese Einrichtung ist es möglich, zum einen das Medium, welches in das Hohlprofil oder Segmente dieses eingebracht ist, auszutauschen. Zum anderen können durch eine Veränderung des Innendruckes andere Dämpfungs- und Härtecharakteristika für das Hohlprofil einstellt werden. Ein weiterer Vorteil einer solchen Einrichtung besteht darin, dass ein Hohlprofil ohne Füllung zwischen die Innen- und Außenbaugruppe eingebracht werden kann und erst im platzierten Zustand mit einem ausgewählten Medium befüllt wird. Somit kann der Einsetzvorgang des Polymerprofils erleichtert werden und ein geeignetes Medium erst vor Ort an Hand des Gewichtes der im Innenrahmen angebrachten Baugruppen bestimmt werden.

Wird das Polymerprofil bei einer quaderförmigen Innenbaugruppe verwendet, so ist es zweckmäßiger Weise aus wenigstens vier im Wesentlichen aneinander stoßenden Profilsträngen ausgebildet.

Eine besonders gute Fixierung des Polymerprofils kann dadurch erreicht werden, dass die Einspannvorrichtung keilförmige, gegeneinander weisende Einspannflächen aufweist. Diese keilförmigen, gegeneinander weisenden Einspannflächen ermöglichen eine besonders einfache und sichere Platzierung des Polymerprofils. Durch diese Einspanneinrichtung ist keine zusätzliche Fixierung des Polymerprofils mehr notwendig. Eine einfache, adhäsive Festlegung, z.B. mittels einer dünnen Klebestelle, zur Unterstützung der Fixierung, ist denkbar. Da dies nur unterstützend wirkt, können Nachteile, wie die bei herkömmlicher hauptsächlich adhäsiver Befestigung auftretenden Probleme, beim Wiederausbau vermieden werden. Weiterhin wird durch diese Ausbildung erreicht, dass das Polymerprofil auch nach großen Schwingungsamplituden nicht aus der Einspanneinrichtung gepresst werden kann. Durch zusätzliche Fortsätze an der Einspanneinrichtung in Anlage mit dem Polymerprofil kann hierbei eine noch höhere Sicherheit und Zuverlässigkeit erreicht werden.

Um das Polymerprofil in seiner Form zu stärken und formstabiler auszubilden, ist es vorteilhaft, ein integriertes oder darin eingebettetes Drahtgewebe vorzusehen. Durch ein solches Drahtgewebe kann die Härte und auch die Dämpfungscharakteristik des Polymerprofils beeinflusst werden. Somit vergrößert sich der Anwendungsbereich eines solchen Profils, da auch Härten erreicht werden können, die aus einem reinen Polymermaterial nicht möglich sind.

Um eine besonders gute Dämpfungswirkung zu erreichen, ist eine Einspannfläche für das Polymerprofil an dem Innenrahmen ausgebildet und eine damit zusammenwirkende Einspannfläche für das Polymerprofil an dem Außenrahmen ausgebildet. Mit dieser Konstruktion wird erreicht, dass das Polymerprofil in geeigneter Weise zwischen den beiden Rahmen gehalten wird und somit die Stöße und Schwingungen, die auf den äußeren Rahmen einwirken, gut, in Bezug auf den Innenrahmen, gedämpft werden. Auch wird durch diese Konstruktion ermöglicht, dass der Innenrahmen keinerlei Berührungspunkte mit dem Außenrahmen aufweist.

Das Polymerprofil ist mit einer Dichtfunktion ausgebildet, insbesondere Staub, Wasser und/ oder EMV-dicht. Weist das Polymerprofil diese Eigenschaften auf, entfällt die Notwendigkeit eines zusätzlichen Gummibalgs zum Abdichten der Seiten und des hinteren Bereiche der in den Innenrahmen eingebrachten Baugruppen. Somit fallen die Probleme, die im Stand der Technik mit dem Einbau eines Gummibalgs auftreten, bei einer derartigen Lagerungsanordnung nicht an. Auch ist es möglich, eine EMV-Dichtigkeit ohne großen zusätzlichen Aufwand zu erreichen, indem das Polymerprofil Zusätze von elektrisch leitenden Kohlefasern oder -partikeln oder ein elektrisch leitendes Gewebe aufweist.

Da der Innenrahmen anders als bei bisher bekannten Systemen nicht mehr an dem Außenrahmen durch Dämpfungselemente aufgehängt ist, ist es vorteilhaft, dass die Härte des Polymerprofils im Standbereich des Außenrahmens größer ist als im entgegengesetzten Bereich. Hiermit wird erreicht, dass der Innenrahmen vertikal zentriert werden kann. Die Härte des Polymerprofils im Standbereich wird bevorzugt größer gewählt, so dass im normalen Betrieb hierauf zusätzlich zu den Stößen auch die Gewichtskraft der im Innenrahmen eingebauten Baugruppen wirkt und dabei größere Kräfte aufgenommen werden können. Dies kann besonders einfach durch eine Segmentierung des Polymerprofils erreicht werden, wobei die unteren Segmente durch Einbringen eines geeigneten Fluids oder Luft eine größere Härte aufweisen können. Ebenso können unterschiedliche Polymerarten verwendet werden, um die Härte zu beeinflussen.

Das zweckmäßiger weise aus Polymermaterial bestehende Dämpfungs- und Dichtungsprofil kann entsprechend dem Einsatzzweck auch als Elastomer oder Gummi, gegebenenfalls auch als Mischungen davon, gewällt sein. Auch elastische, dichtende Kunststoffmaterialien oder Mischungen dieser Materialarten sind einsetzbar.

Im Hinblick auf gewünschte Dämpfungscharakteristika kann das Profil zum Beispiel durch eine Vorspannung in X-Richtung eine höhere Federsteifigkeit in Z-Richtung erhalten. In diesem Sinn kann das Profil zum Beispiel eine ca. 1,5-fach höhere Federsteifigkeit in Z-Richtung als in X-Richtung aufweisen.

In der Konfiguration des Profiles ist anzustreben in Eckbereichen der Anlageeinrichtung eine weitgehend komplementäre Form beim Profil zu erhalten, so dass eine formschlüssige Anlage erreicht wird. So kann ein ovalartiges Dichtungsprofil etwa spitz zulaufende Endbereiche in den Anlagebereichen aufweisen.

Die Anlageeinrichtung zwischen Außengehäuse und innerem Schwingrahmen sollte zweckmäßiger Weise zum Beispiel bei Schrägflächen so ausgebildet sein, dass die keilförmigen Endpunkte bzw. Endbereiche eine Erstreckung in Höhenrichtung Y des Außengehäuses aufweisen, die es erlaubt, den inneren Schwingrahmen in horizontaler X-Richtung ungehindert in den Innenraum des Außengehäuses einführen zu können.

Im Falle einer ovalförmigen Hohldichtung, welche zwischen den Schrägflächen mit Vorspannung einbringbar ist, sind ausreichende Ausdehnungsbereiche, zum Beispiel etwa parallel zu den Schrägflächen der Anlageeinrichtung, vorhanden, um bei Stoßei-nwirkungen relativ weiche Abfederungseigenschaften für das Schwinggehäuse zu erreichen.

Eine gewünschte Steifigkeit des Dämpfungsprofiles kann auch durch die auf das Dämpfungsprofil aufgebrachte Vorspannung eingestellt werden. Für diesen Zweck ist es bei Schrägflächen der Anlageeinrichtung möglich, den relativen Abstand dieser Flächen gegeneinander einstellbar zu gestalten. Anstelle von Schrägflächen können auch andere etwa käfigartige Aufnahme- bzw. Führungseinrichtungen für das Dichtungsprofil vorgesehen sein.

Die Konfiguration des Profiles ist in Abstimmung mit der Führungs- und Anlageeinrichtung für das Profil und den zu erwartenden einwirkenden Kräften so abzustimmen, dass auch bei maximaler Belastung der maximale Abstand zwischen Außengehäuse und Schwingrahmen mittels der gewählten Konfiguration des Profiles noch ausreichend dicht abgeschlossen werden kann. Die Profilgestaltung sollte im Hinblick auf Anlageflächen und Kanten so gewählt werden, dass Kantenbelastungen auf das Profil vermieden werden können.

Profile aus Gummimaterial, zum Beispiel Neopren mit einer Härte von 50 Shore A oder im Bereich von 45 bis 60 Shore, mit Wandstärken von etwa 3 bis 5 mm bei Hohlprofilen, erscheinen sehr zweckmäßig, um einwirkende Kräfte, auch wenn diese schockartig oder dauerschockartig sind, gut abfedern und dämpfen zu können.

Bevorzugt wird eine solche Lagerungs-Anordnung in einem Gerätekoffer für ein Außengehäuse und einen darin angebrachten inneren Schwingrahmen vorgesehen. Besonders vorteilhaft ist es, wenn der Schwingrahmen als Rahmengestell ausgebildet ist, und auf mindestens einer Frontseite des Außengehäuses ein abnehmbarer Abschlussdeckel vorgesehen ist, wobei das Polymerprofil eine Dämpfungsvorrichtung für das Rahmengestellt im Innenbereich des Gerätekoffers bildet. Somit können bei einem solchen Gerätekoffer die komplizierten Schwingungsdämpfungselemente, wie sie aus dem Stand der Technik bekannt sind, entfallen. Auch ist es nicht mehr notwendig, zur Abdichtung der eingebauten Baugruppen bei geöffnetem Abschlussdeckel einen Gummibalg vorzusehen, welcher die Dämpfungswirkung der Dämpfungselemente negativ beeinflusst hat.

Durch das Verwenden der erfindungsgemäßen Lagerungs-Anordnung ist das Polymerprofil gleichzeitig eine Dichteinrichtung für in das Rahmengestell einsetzbare Geräte und Baugruppen. So können wesentliche Nachteile, die aus dem Stand der Technik bekannt sind, durch das Verwenden dieser Lagerungs-Anordnung mit einem Polymerprofil überwunden werden, und ein einfaches aber dennoch flexibles kombiniertes Dämpfungs- und Dichtungssystem bei einem Gerätekoffer erreicht werden.

Die Erfindung wird nachfolgend anhand eines Ausführungsbeispiels und schematischer Zeichnungen näher erläutert. In diesen Zeichnungen zeigen:
- Fig. 1: eine Seitenansicht eines Längsschnittes durch einen Gerätekoffer mit einer erfindungsgemäßen Lagerungs-Anordnung ;
- Fig. 2: eine vergrößerte Ansicht einer Lagerungs-Anordnung nach Fig. 1, im Schnitt in einem Gerätekoffer; und
- Fig. 3: eine vergleichbare Ansicht der Lagerungs-Anordnung nach Fig. 2 in einem Gerätekoffer mit frontseitig aufgebrachtem Abschlussdeckel.

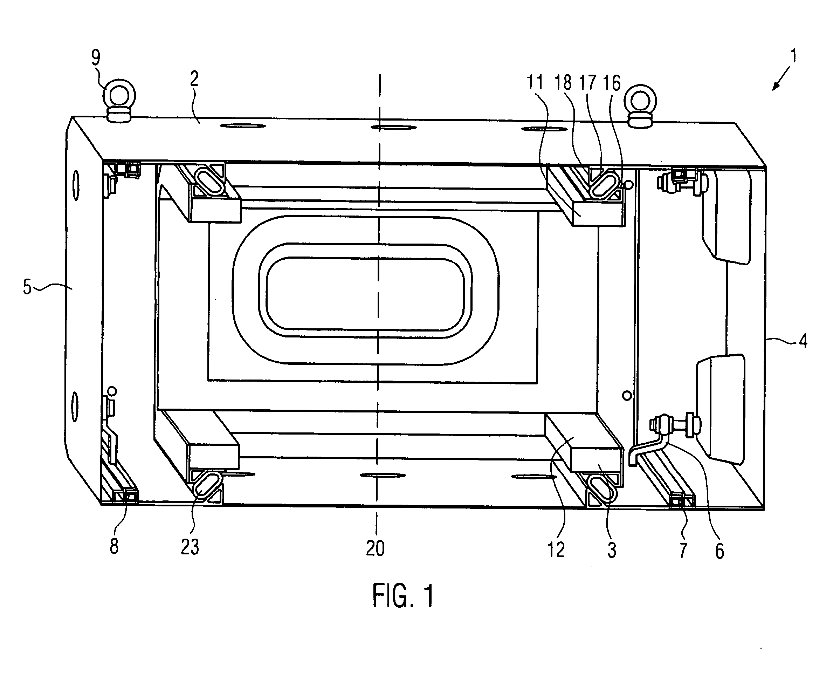

Fig. 1 zeigt einen Längsschnitt einer Seitenansicht eines Gerätekoffers 1. Der Gerätekoffer 1 besteht aus einer Außenbaugruppe 2, die in diesem Fall ein Gehäuse ist, und einer Innenbaugruppe 3, die als Schwingrahmen ausgeführt ist. Der Gehäusekoffer 1 besitzt außerdem einen vorderen Abschlussdeckel 4 und einen hinteren Abschlussdeckel 5. Diese Abschlussdeckel 4, 5 werden mit Hilfe von Drehverschlüssen 6 an dem Gehäuse 2 befestigt. Um ein Eindringen von Feuchtigkeit oder Schmutzpartikeln in den geschlossenen Gehäusekoffer 1 zu verhindern, sind an den Stirnseiten des Gehäusekoffers 1 äußere Dichtungseinrichtungen 7, 8 vorgesehen. Diese sind so ausgebildet, dass sie bei geschlossenen Abschlussdeckeln 4, 5 das Gehäuse weitgehend wasserdicht abdichten können. Im oberen Bereich des Gehäusekoffers 1 sind zwei Transportösen 9 sichtbar. An ihnen können Transporteinrichtungen angreifen, um z.B. einen vollbestückten Gerätekoffer 1 anzuheben oder an geeigneten Einrichtungen zu befestigen.

Der Schwingrahmen 3 weist hier nicht dargestellte Einrichtungen auf, um darin Baugruppen aufnehmen, und befestigen zu können. Sind diese Baugruppen in den Schwingrahmen eingebracht, so verschließen sie mit ihren Frontplatten den Bereich zwischen dem oberen Holm 11 und dem unteren Holm 12. Zur Dämpfung weist der Gerätekoffer 1 eine Lagerungs-Anordnung 10 aus einem äußeren Teil einer Einspanneinrichtung 18 und einem inneren Teil einer Einspanneinrichtung 16 auf. Zwischen diesen beiden Teilen der Einspanneinrichtung 16, 18 befindet sich ein Polymerprofil 17. In der dargestellten Ausführungsform ist das Polymerprofil 17 ovalförmig und als Hohlprofil ähnlich einem Schlauch ausgebildet.

Der Gerätekoffer 1 weist in dieser Ausführungsform zwei Anlageeinrichtungen 30 für Polymerprofile 17, 23 auf. Diese beiden Anlageeinrichtungen 30 befinden sich an beiden Enden des Gerätekoffers 1. Im Ausführungsbeispiel, nach Fig. 1 sind sowohl beide Anlageeinrichtungen 30 wie auch beide darin vorgesehenen Polymerprofile 17, 23 umlaufend um den gesamten Innenumfang des Gerätekoffers 1, ausgebildet. Die beiden Anlageeinrichtungen 30 sind zur Mittelachse 20 symmetrisch bzw. spiegelsymmetrisch aufgebaut. Ein solcher Aufbau gestattet es daher, auf Außengehäuse 2 und/oder innerem Schwingrahmen 3 horizontal, vertikal und/oder seitlich einwirkende Kräfte für die eingebauten Baugruppen in optimaler Weise zu dämpfen oder zu eliminieren. Durch die Verwendung der Lagerungs-Anordnungen 10 in dem Gehäusekoffer 1, die achsensymmetrisch zur Mittelachse 20 aufgebaut sind, kann daher eine Dämpfungswirkung in allen drei Koordinatenrichtungen erreicht werden.

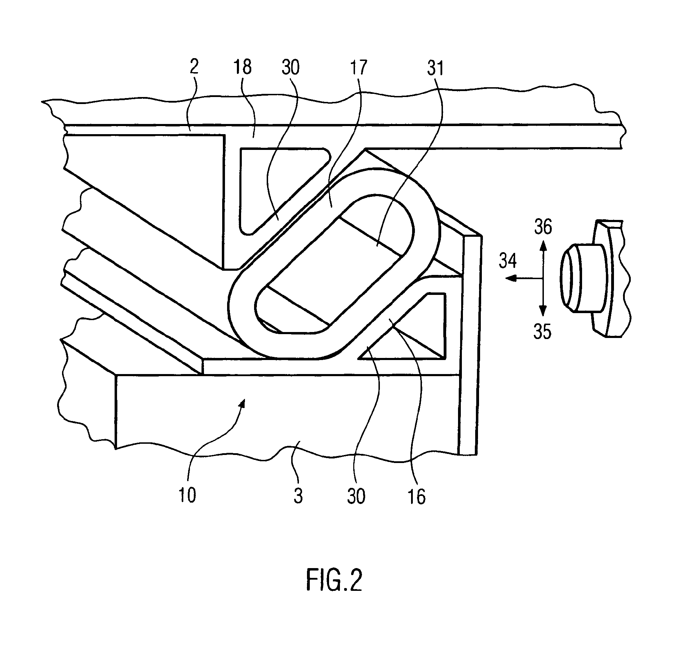

Eine Lagerungs-Anordnung 10 ist in Fig. 2 ausschnittsweise in einer geschnittenen, vergrößerten Ansicht genauer dargestellt. Das hier verwendete Polymerprofil 17 weist einen Hohlraum 31 auf. Dieser Hohlraum 31 kann mit einem beliebigen Medium befüllt sein, wodurch die Dämpfungseigenschaften des Polymerprofils 17 beeinflusst und eingestellt werden können. An der Au-ßenbaugruppe 2 ist der äußere Teil der Einspannvorrichtung 18 als ein keilförmiger Vorsprung vorgesehen. Gegenüber dem keilförmigen äußeren Teils der Einspanneinrichtung 18 befindet sich der innere Teil der Einspanneinrichtung 16. Dieser bildet das Gegenstück zu der äußeren Einspanneinrichtung 18 und ist an der Innenbaugruppe 3 befestigt. Mit der in der Fig. 2 dargestellten Lagerungs-Anordnung 10 können Kräfte in den Richtungen 34, 35 und 36 und daraus resultierende Kräfte aufgenommen und gedämpft werden.

Wie aus Fig. 2 ersichtlich, liegt das Polymerprofil sowohl am äußeren Teil der Einspanneinrichtung 18, wie auch am inneren Teil der Einspanneinrichtung 16 wirk- und/oder formschlüssig an. Es ist daher mit dieser Lagerungs-Anordnung 10 neben der Dämpfung der Innenbaugruppe 3 auch möglich, das Eindringen von Schmutz oder Feuchtigkeit durch den Schlitz zwischen innerer und äußerer Baugruppe zu verhindern. Ein Gummibalg, wie er im Stand der Technik genutzt wird, ist überflüssig.

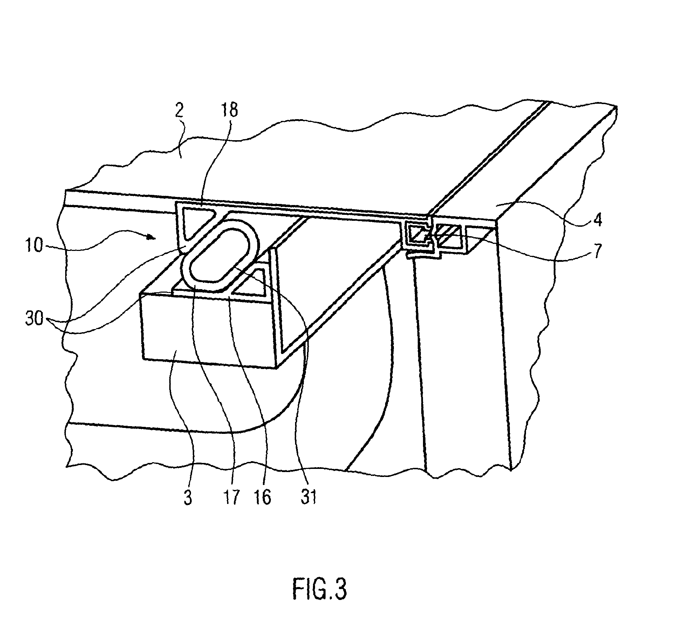

Fig. 3 zeigt ebenfalls eine Lagerungs-Anordnung 10 in einem Gerätekoffer 1 in einem größeren Ausschnitt. Am Gehäuse 2 ist der äußere Teil der Einspanneinrichtung 18 angebracht. Daran anliegend und kraftmäßig eingespannt ist das Polymerprofil 17, welches als Hohlprofil ausgebildet ist, vorgesehen. Gegenüber dem äußeren Teil der Einspanneinrichtung 18 befindet sich der Innenteil der Einspanneinrichtung 16. Dieser Teil der Einspanneinrichtung 16 ist an dem Innenschwingrahmen 3 befestigt. Weiterhin ist in dieser Fig. 3 die äußere Dichtungseinrichtung 7 dargestellt, die zusammen mit dem Abschlussdeckel 4 den Gehäusekoffer 1 vor äußeren Umwelteinflüssen abdichtet. Die Dichtwirkung der Lagerungs-Anordnung 10 kommt voll zur Wirkung, wenn der Abschlussdeckel 4 abgenommen ist und in dem Schwingrahmen 3 eingebaute Geräte oder Baugruppen (nicht dargestellt), vorhanden sind.

Die erfindungsgemäße Lagerungs-Anordnung 10 bietet somit ein einfaches und flexibles Konzept, um einen Innenrahmen zu einem Außenrahmen schwingungsgedämpft anzubringen und zusätzlich eine optimale Dichtfunktion zu erreichen.

## Patentansprüche

1. Lagerungs-Anordnung
für eine Innenbaugruppe (3) in einer Außenbaugruppe (2), insbesondere für einen inneren Schwingrahmen (3) in einem Außenrahmen eines Außengehäuses (2),
mit einer Dämpfungsvorrichtung zwischen Innen- (3) und Außenbaugruppe (2) zur Aufnahme von in bis zu drei Koordinatenrichtungen relativ auf die Innen- (3) und Außenbaugruppe (2) einwirkenden Kräften,
wobei die Dämpfungsvorrichtung im Wesentlichen als mindestens ein zwischen Innen- (3) und Außenbaugruppe (2) umlaufendes elastisches Polymerprofil (17, 23), insbesondere mit zwei Polymerprofilen (17, 23), ausgebildet ist,
**dadurch gekennzeichnet,**
**dass** die Innen- (3) und Außenbaugruppe (2) mit einer Anlageeinrichtung (30) für das bzw. die elastische(n) Polymerprofil(e) (17, 23) ausgestattet ist (sind),
**dass** das Polymerprofil (17, 23) zwischen Innen- (3) und Außenbaugruppe (2) im Bereich der Anlageeinrichtung (30) vorgesehen ist und mit Dichtfunktion ausgebildet ist, insbesondere staub-, wasser- und/oder EMV-dicht ist, und **dass** die Anlageeinrichtung (30) zwei gegeneinander weisende, insbesondere parallele und schräge, Flächen (16, 18) aufweist, zwischen denen das Polymerprofil (17, 23) vorgesehen ist.

2. Anordnung nach Anspruch 1,
**dadurch gekennzeichnet**
**dass** an beiden Endbereichen der Innenbaugruppe (3) jeweils mindestens eine Anlageeinrichtung (30) für das Polymerprofil (17, 23) vorgesehen ist, und
**dass** die beiden Anlageeinrichtungen (30) im Wesentlichen spiegelsymmetrisch zur "Mittelachse" (20) der Innenbaugruppe (3) ausgelegt sind.

3. Anordnung nach Anspruch 1 oder 2,
**dadurch gekennzeichnet,**
**dass** die Anlageeinrichtung (30) als Führungs- oder Einspanneinrichtung ausgebildet ist.

4. Anordnung nach einem der Ansprüche 1 bis 3,
**dadurch gekennzeichnet,**
**dass** das Polymerprofil (17, 23) als Voll- oder Hohlprofil ausgebildet ist.

5. Anordnung nach Anspruch 4,
**dadurch gekennzeichnet,**
**dass** das Polymerprofil (17, 23) großflächig mit der Anlageeinrichtung (30) in Wirkverbindung steht.

6. Anordnung nach einem der Ansprüche 1 bis 5,
**dadurch gekennzeichnet ,**
**dass** das Polymerprofil (17, 23) als ring-, oval- oder kreisförmiges Hohlprofil ausgebildet ist.

7. Anordnung nach einem der Ansprüche 1 bis 6,
**dadurch gekennzeichnet,**
**dass** das Polymerprofil (17, 23) einstückig umlaufend oder segmentiert ausgebildet ist.

8. Anordnung nach einem der Ansprüche 1 bis 7,
**dadurch gekennzeichnet,**
**dass** das Polymerprofil (17, 23) in Teilbereichen mit unterschiedlicher Härte- und/oder Dämpfungscharakteristik ausgebildet ist.

9. Anordnung nach einem der Ansprüche 1 bis 8,
**dadurch gekennzeichnet,**
**dass** die Härte- und/oder Dämpfungscharakteristik mittels eines in das Hohlprofil oder Segmente des Hohlprofils des Polymerprofils (17, 23) eingebrachten Mediums und/oder die Einspannung des Polymerprofils (17, 23) in der Anlageeinrichtung (30) einstellbar ist.

10. Anordnung nach einem der Ansprüche 1 bis 9,
**dadurch gekennzeichnet,**
**dass** eine Einrichtung zum Variieren der Menge und/oder des Druckes des in das Hohlprofil eingebrachten Mediums vorgesehen ist.

11. Anordnung nach einem der Ansprüche 1 bis 10,
**dadurch gekennzeichnet,**
**dass** das Polymerprofil (17, 23) bei einer quaderförmigen Innenbaugruppe (3) mittels wenigstens vier im Wesentlichen aneinander stoßenden Profilsträngen gebildet ist.

12. Anordnung nach einem der Ansprüche 3 bis 11,
**dadurch gekennzeichnet,**
**dass** die Einspanneinrichtung (30) keilförmige gegeneinander weisende Einspannflächen (16, 18) für das Polymerprofil (17, 23) aufweist.

13. Anordnung nach einem der Ansprüche 1 bis 12,
**dadurch gekennzeichnet,**
**dass** das Polymerprofil (17, 23) ein integriertes oder darin eingebettetes Drahtgewebe aufweist.

14. Anordnung nach Anspruch 12 oder 13,
**dadurch gekennzeichnet,**
**dass** eine Einspannfläche (16) für das Polymerprofil (17, 23) an dem Innenrahmen (3) ausgebildet ist, und
**dass** eine damit zusammenwirkende Einspannfläche (18) für das Polymerprofil (17, 23) an den Außenrahmen (2) ausgebildet ist.

15. Anordnung nach einem der Ansprüche 1 bis 14,
**dadurch gekennzeichnet,**
**dass** die Härte des Polymerprofils (17, 23) im Standbereich des Außenrahmens (2) größer ist, als im entgegengesetzten Bereich.

16. Gerätekoffer (1) mit einer Lagerungs-Anordnung nach einem der Ansprüche 1 bis 15, für ein Außengehäuse (2) und einen darin angebrachten inneren Schwingrahmen (3).

17. Gerätekoffer nach Anspruch 16,
**dadurch gekennzeichnet,**
**dass** der Schwingrahmen (3) als Rahmengestell ausgebildet ist,
**dass** auf mindestens einer Frontseite des Außengehäuses (2) ein abnehmbarer Abschlussdeckel (4, 5) vorgesehen ist, und
**dass** das Polymerprofil (17, 23) eine Dämpfungsvorrichtung für das Rahmengestell im Innenbereich (3) des Gerätekoffers (1) bildet.

18. Gerätekoffer nach Anspruch 17,
**dadurch gekennzeichnet,**
**dass** das Polymerprofil (17, 23) eine Dichteinrichtung für in das Rahmengestell (3) einsetzbare Geräte und Baugruppen bildet.

## Claims

1. Suspension device for an inner subassembly (3) in an outer subassembly (2), particularly for an inner swing frame (3) in an outer frame of an outer housing (2), having a damping device between the inner subassembly (3) and the outer subassembly (2) for absorbing forces acting in up to three coordinate directions relative to the inner subassembly (3) and outer subassembly (2), in which the damping device is essentially constructed as at least one circumferential elastic polymer profile (17, 23) between inner subassembly (3) and outer subassembly (2) and in particular having two polymer profiles (17, 23), **characterized in that** the inner subassembly (3) and outer subassembly (2) are equipped with a locating device (30) for the elastic polymer profile(s) (17, 23), that the polymer profile (17, 23) is provided between inner subassembly (3) and outer subassembly (2) in the vicinity of the locating device (30) and is constructed with a sealing function and is in particular tight to dust, water and/or EMC, and that the locating device (30) has two more particularly parallel and sloping surfaces (16, 18) directed against one another and between which the polymer profile (17, 23) is located.

2. Device according to claim 1, **characterized in that** on each of the two end regions of the inner subassembly (3) is provided at least one locating device (30) for polymer profile (17, 23) and that the two locating devices (30) are designed in a substantially mirror symmetrical manner to the "central axis" (20) of inner subassembly (3).

3. Device according to claim 1 or 2, **characterized in that** the locating device (30) is constructed as a guiding or clamping device.

4. Device according to one of the claims 1 to 3, **characterized in that** the polymer profile (17, 23) is constructed as a solid or hollow profile.

5. Device according to claim 4, **characterized in that** the polymer profile (17, 23) is in large-area operative connection with locating device (30).

6. Device according to one of the claims 1 to 5, **characterized in that** the polymer profile (17, 23) is constructed as a ring-like, oval or circular hollow profile.

7. Device according to one of the claims 1 to 6, **characterized in that** the polymer profile (17, 23) is constructed in integral circumferential or segmented manner.

8. Device according to one of the claims 1 to 7, **characterized in that** partial areas of the polymer profile (17, 23) are constructed with different hardness and/or damping characteristics.

9. Device according to one of the claims 1 to 8, **characterized in that** the hardness and/or damping characteristics by means of a medium introduced into the hollow profile or segments of said hollow profile of polymer profile (17, 23) and/or the clamping of the polymer profile (17, 23) in the locating device (30) can be adjusted:

10. Device according to one of the claims 1 to 9, **characterized in that** an apparatus is provided for varying the quantity and/or pressure of the medium introduced into the hollow profile.

11. Device according to one of the claims 1 to 10, **characterized in that**, in the case of a parallelepipedic inner subassembly (3), the polymer profile (17, 23) is formed by at least four substantially abutting profile strands.

12. Device according to one of the claims 3 to 11, **characterized in that** the clamping device (30) has wedge-shaped clamping surfaces (16, 18), directed against one another, for the polymer profile (17, 23).

13. Device according to one of the claims 1 to 12, **characterized in that** the polymer profile (17, 23) has an integrated or embedded therein wire gauze.

14. Device according to claim 12 or 13, **characterized in that** a clamping surface (16) for polymer profile (17, 23) is formed on the inner frame (3) and that a clamping surface (18), cooperating therewith, for polymer profile (17, 23) is formed on outer frame (2).

15. Device according to one of the claims 1 to 14, **characterized in that** the hardness of the polymer profile (17, 23) in the standing area of outer frame (2) is greater than in the opposite area.

16. Toolbox (1) with a suspension device according to one of the claims 1 to 15, for an outer housing (2) and an inner swing frame (3) fitted therein.

17. Toolbox according to claim 16, **characterized in that** the swing frame (3) is constructed as a rack, that a removable cover plate (4, 5) is provided on at least one front side of outer housing (2) and that the polymer profile (17, 23) forms a damping device for the rack in the inner area (3) of the toolbox (1).

18. Toolbox according to claim 17, **characterized in that** the polymer profile (17, 23) forms a sealing device for tools and subassemblies which can be inserted in rack (3).

## Revendications

1. Dispositif de rangement pour un ensemble intérieur (3) dans un ensemble extérieur (2), notamment pour un châssis oscillant intérieur (3) dans un châssis extérieur d'un boîtier extérieur (2), comprenant
un dispositif d'amortissement entre l'ensemble intérieur (3) et l'ensemble extérieur (2) pour recevoir des forces agissant jusque dans trois directions de coordonnées par rapport à l'ensemble intérieur (3) et l'ensemble extérieur (2),
le dispositif d'amortissement étant réalisé principalement comme au moins un profil de polymère (17, 23) élastique, périphérique, entre l'ensemble intérieur (3) et l'ensemble extérieur (2), formé notamment de deux profilés en polymère (17, 23),
**caractérisé en ce que**
l'ensemble intérieur (3) et l'ensemble extérieur (2) sont équipés d'une installation d'appui (30) pour le ou les profilés en polymère élastique (17, 23),
le profilé en polymère (17, 23) est prévu entre l'ensemble intérieur et l'ensemble extérieur (2) au niveau de l'installation d'appui (30) et assure une fonction d'étanchéité, notamment l'étanchéité à la poussière, à l'eau et/ou aux ondes électromagnétiques, et
l'installation d'appui (30) comporte deux surfaces (16, 18) tournées l'une vers l'autre, notamment parallèles et inclinées, entre lesquelles se trouve le profilé en polymère (17, 23).

2. Dispositif selon la revendication 1,
**caractérisé en ce que**
dans les deux zones d'extrémité de l'ensemble intérieur (3), il est prévu au moins une installation d'appui (30) pour le profilé en polymère (17, 23), et
les deux installations d'appui (30) sont réalisées pour l'essentiel de manière symétrique plane par rapport à « l'axe central » (20) de l'ensemble intérieur (3).

3. Dispositif selon la revendication 1 ou 2,
**caractérisé en ce que**
l'installation d'appui (30) est réalisée comme installation de guidage ou de serrage.

4. Dispositif selon l'une des revendications 1 à 3,
**caractérisé en ce que**
le profilé en polymère (17, 23) est un profilé plein ou creux.

5. Dispositif selon la revendication 4,
**caractérisé en ce que**
le profilé en polymère (17, 23) coopère en grande surface avec l'installation d'appui (30).

6. Dispositif selon l'une des revendications 1 à 5,
**caractérisé en ce que**
le profilé en polymère (17, 23) est un profilé creux en anneau, en ovale ou en cercle.

7. Dispositif selon l'une des revendications 1 à 6,
**caractérisé en ce que**
le profilé en polymère (17, 23) est réalisé en une seule pièce périphérique ou par segments.

8. Dispositif selon l'une des revendications 1 à 7,
**caractérisé en ce que**
le profilé en polymère (17, 23) est réalisé en zones partielles de dureté et/ou de caractéristique d'amortissement différentes.

9. Dispositif selon l'une des revendications 1 à 8,
**caractérisé en ce que**
la caractéristique de dureté et/ou d'amortissement est réglée à l'aide d'un milieu introduit dans le profilé creux ou dans des segments du profilé creux en polymère (17, 23), et/ou on peut régler la contrainte de serrage du profilé de polymère (17, 23) dans l'installation d'appui (30).

10. Dispositif selon l'une des revendications 1 à 9,
**caractérisé par**
une installation pour modifier la quantité et/ou la pression du milieu introduit dans le profilé creux.

11. Dispositif selon l'une des revendications 1 à 10,
**caractérisé en ce que**
le profilé en polymère (17, 23) est formé pour un ensemble intérieur (3) de forme parallélépipédique avec au moins quatre cordons de profilés qui se rejoignent pratiquement.

12. Dispositif selon l'une des revendications 3 à 11,
**caractérisé en ce que**
l'installation de serrage (30) comporte des surfaces de serrage (16, 18) inclinées l'une vers l'autre en forme de coins, pour le profilé en polymère (17, 23).

13. Dispositif selon l'une des revendications 1 à 12,
**caractérisé en ce que**
le profilé en polymère (17, 23) comporte un tissu de fils intégrés ou insérés.

14. Dispositif selon l'une des revendications 12 ou 13,
**caractérisé par**
une surface de serrage (16) pour le profilé en polymère (17, 23) sur le cadre intérieur (3) et une surface de serrage (18) coopérant avec celui-ci pour le profilé en polymère (17, 23) est réalisée sur le cadre extérieur (2).

15. Dispositif selon l'une des revendications 1 à 14,
**caractérisé en ce que**
dans la zone d'appui du cadre extérieur (2), la dureté du profilé en polymère (17, 23) est supérieure à celle dans la zone opposée.

16. Coffre à appareil (1) comportant un dispositif de rangement selon l'une des revendications 1 à 15, pour un boîtier extérieur (2) et un châssis oscillant (3) intérieur placé dans celui-ci.

17. Coffre à appareil selon la revendication 16,
**caractérisé en ce que**
le châssis oscillant (3) est en forme de cadre,
au moins une face frontale du boîtier extérieur (2) comporte un couvercle de fermeture (4, 5) amovible, et
le profilé en polymère (17, 23) comporte un dispositif d'amortissement pour le cadre (3) dans la zone intérieure du coffre à appareil (1).

18. Coffre à appareil selon la revendication 17,
**caractérisé en ce que**
le profilé en polymère (17, 23) forme une installation d'étanchéité pour des appareils et des ensembles insérés dans le cadre (3).
